Europäisches Patentamt

European Patent Office

Office européen des brevets

(19)

(11) **EP 0 775 916 A1**

## (12) DEMANDE DE BREVET EUROPEEN

(43) Date de publication:
**28.05.1997  Bulletin 1997/22**

(51) Int Cl.⁶: **G01R 31/04**, H01R 13/629

(21) Numéro de dépôt: **96402147.1**

(22) Date de dépôt: **10.10.1996**

(84) Etats contractants désignés:
**DE ES GB IT PT**

(30) Priorité: **23.11.1995  FR 9513907**

(71) Demandeur: **S.M. Contact S.a.r.l.**
**77580 Crécy la Chapelle (FR)**

(72) Inventeur: **Roshardt, Christophe**
**77400 Thorigny sur Marne (FR)**

(74) Mandataire: **Bonnetat, Christian**
**CABINET BONNETAT**
**29, rue de St. Pétersbourg**
**75008 Paris (FR)**

(54) **Dispositif de contrôle pour connecteurs électriques**

(57)     -La présente invention concerne un dispositif de contrôle pour un connecteur électrique (2), comportant notamment un évidement (4) pour recevoir le connecteur (2) et un loquet (8) monté sur un organe mobile (6) et susceptible, soit de dégager complètement l'évidement (4) pour permettre l'introduction et l'extraction du connecteur (2), soit de bloquer le connecteur (2) dans l'évidement (4).

-     Selon l'invention, le loquet (8) est monté flottant sur l'organe mobile (6), l'extrémité du loquet (8), en regard de l'évidement (4), présente deux faces (12A, 12B) destinées à venir au contact respectivement de la face arrière (2A) et d'une face latérale (2B) du connecteur (2), et l'extrémité du loquet (8), opposée à l'évidement (4), présente une face (13A) destinée à coulisser sur une face d'appui (13B) du dispositif.

FIG.1

## Description

La présente invention concerne un dispositif de contrôle pour connecteurs électriques, permettant de tester, par exemple, des câbles, faisceaux et harnais électriques utilisés dans les industries automobile, aéronautique ou de l'électroménager.

On sait que de tels connecteurs électriques comportent des broches (mâle ou femelle) auxquelles sont reliées mécaniquement et électriquement les extrémités de conducteurs électriques aboutissant auxdits connecteurs. L'objet d'un tel dispositif de contrôle est de vérifier qu'il y a contact électrique entre chacun desdits conducteurs et la broche qui lui correspond et/ou que chaque broche est bien rendue solidaire (par exemple par encliquetage) du connecteur auquel elle appartient. On peut également contrôler la présence de joints, de grilles, etc ...

On connaît de nombreux dispositifs de contrôle de ce type, notamment par le document FR-A-2 690 250. Ce document divulgue un dispositif de contrôle qui comporte :

- un organe de réception pourvu d'un évidement de forme correspondant à celle dudit connecteur, et susceptible de recevoir ledit connecteur ;
- des tiges de contact connectées électriquement à un appareil électrique de contrôle et disposées de manière correspondant à celle desdites broches ;
- des moyens de détection pour détecter l'introduction dudit connecteur dans ledit évidement ; et
- des moyens de blocage permettant de bloquer ledit connecteur dans ledit évidement, dans une position de blocage pour laquelle lesdites broches sont en contact d'aboutement avec lesdites tiges de contact, lesdits moyens de blocage comprenant :

  . un organe mobile dans les deux sens, parallèlement à la direction longitudinale d'introduction et d'extraction dudit connecteur, dans ledit évidement, susceptible de prendre deux positions extrêmes ;
  . un loquet monté sur ledit organe mobile et susceptible pour l'une desdites positions extrêmes dudit organe mobile de dégager complètement ledit évidement pour permettre la libre introduction par l'avant et la libre extraction dudit connecteur, dans ledit évidement, et, pour l'autre position extrême dudit organe mobile de prendre appui sur ledit connecteur pour le bloquer dans ledit évidement dans ladite position de blocage, en pressant lesdites broches contre lesdites tiges de contact ; et
  . des moyens d'actionnement dudit organe mobile commandés, dans le sens du blocage, par lesdits moyens de détection, et, dans le sens du déblocage, par un organe de déblocage.

De plus, on notera que, dans ce document FR-A-2 690 250, ledit dispositif de contrôle présente les particularités suivantes :

- les moyens de blocage sont agencés de façon externe, à côté de l'organe de réception, et sont reliés à ce dernier par l'intermédiaire d'un support fixe ;
- le loquet est monté de façon rotative sur ledit support fixe, une extrémité dudit loquet étant agencée sur l'organe mobile et l'autre extrémité étant libre et susceptible de se déplacer, en arc de cercle, entre deux positions extrêmes sous l'action dudit organe mobile. Comme précisé ci-dessus, pour l'une desdites positions extrêmes, cette extrémité libre du loquet dégage l'évidement et, pour l'autre position extrême, elle presse le connecteur contre le fond de l'évidement.

Un tel dispositif de contrôle connu, comportant les particularités précédentes, présente de nombreux inconvénients, notamment :

- le loquet doit être très long pour pouvoir pénétrer suffisamment dans l'évidement lors de la mise en place du connecteur ;
- ledit dispositif de contrôle présente un encombrement important, en particulier en raison de l'agencement externe latéral des moyens de blocage et de la taille importante du loquet ; et surtout
- en raison du mouvement en arc de cercle de l'extrémité de pressage du loquet, le contact entre cette extrémité de pressage et la face arrière du connecteur n'est pas stable, ce qui risque de provoquer un mauvais positionnement du connecteur, et surtout une mise en biais de celui-ci dans l'évidement, empêchant alors son introduction complète.

La présente invention a pour objet de remédier à ces inconvénients. Elle concerne un dispositif de contrôle du type décrit précédemment, peu encombrant et de coût réduit, permettant de réaliser une introduction sûre et précise du connecteur, dans l'organe de réception prévu à cet effet dans ledit dispositif de contrôle.

A cet effet, selon l'invention, ledit dispositif de contrôle comportant un organe de réception, des tiges de contact, des moyens de détection et des moyens de blocage, tels que ceux décrits précédemment, est remarquable en ce que ledit loquet est monté flottant sur ledit organe mobile, en ce que l'extrémité dudit loquet, opposée à l'évidement, présente une face destinée à venir au contact d'une face d'appui dudit dispositif de contrôle, parallèle à ladite direction longitudinale, et à coulisser sur cette face d'appui, lors du déplacement dudit organe mobile dans le sens du blocage, de manière à maintenir ledit loquet dans un plan sensiblement orthogonal à ladite direction longitudinale, et en ce que l'extrémité dudit loquet, en regard dudit évidement, présente une première face destinée à venir au contact de la face arrière dudit connecteur et une seconde face destinée à venir au contact d'une face latérale dudit connecteur, lors du déplacement dudit organe mobile dans le sens du blocage, de sorte que ledit loquet exerce sur ledit connecteur, lors d'un tel déplacement dudit organe mobile, simultanément :

- une poussée latérale réalisant le guidage dudit connecteur dans ledit évidement ; et
- une poussée longitudinale provoquant l'introduction complète dudit connecteur dans ledit évidement.

Ainsi, grâce à cette poussée latérale, le connecteur est guidé dans l'évidement et il ne risque pas de se mettre de biais, avant d'être suffisamment introduit pour que le guidage soit réalisé directement par le contact entre la face externe du connecteur et la face interne de l'évidement. Ceci est particulièrement avantageux pour des connecteurs présentant une dimension longitudinale importante, pour lesquels le risque de mise en biais est généralement élevé lors de l'introduction dans des dispositifs de contrôle connus.

De plus, par le double contact superficiel créé entre le loquet et le connecteur, ce dernier est stabilisé lors de son introduction.

En outre, le loquet conforme à l'invention peut présenter des dimensions beaucoup plus réduites qu'un loquet rotatif, tel que celui décrit dans le document antérieur précité, ce qui permet de diminuer l'encombrement dudit dispositif de contrôle.

De façon avantageuse, le dispositif de contrôle conforme à l'invention comporte une butée transversale, sur laquelle prend appui l'extrémité du loquet, opposée à l'évidement, lors du déplacement de l'organe mobile dans le sens du déblocage, de manière à provoquer le basculement dudit loquet qui dégage alors ledit évidement.

En outre, avantageusement, le déplacement de l'organe mobile est engendré, dans le sens du blocage, par un fluide sous pression, susceptible d'être introduit dans une partie d'un espace cylindrique entourant ledit organe mobile, et, dans le sens du déblocage, par au moins un ressort comprimé.

Dans ce cas, de préférence :

- les moyens de détection sont susceptibles de permettre et d'empêcher l'introduction du fluide sous pression dans ladite partie de l'espace cylindrique, lesdits moyens de détection permettant cette introduction lorsqu'ils détectent l'introduction du connecteur dans l'évidement ; et/ou
- ledit organe de déblocage est formé de manière à relier à l'atmosphère, lorsqu'il est actionné, la partie dudit espace cylindrique contenant ledit fluide sous pression.

Dans un mode de réalisation avantageux de l'invention, lesdits moyens de blocage sont complètement intégrés dans ledit dispositif de contrôle, ce qui permet notamment de réduire l'encombrement dudit dispositif. Ce mode de réalisation très compact est particulièrement avantageux, lorsqu'on prévoit d'utiliser lors d'un contrôle une pluralité de dispositifs, tels que le dispositif conforme à l'invention, qui sont agencés côte à côte sur une planche de câblage, pour reproduire des positions sensiblement identiques à celles occupées par les connecteurs en situation de fonctionnement, par exemple dans un véhicule automobile, avec des fils de longueurs adaptées.

De plus, de façon avantageuse, le dispositif de contrôle conforme à l'invention comporte, d'une part, un système de contrôle comprenant ledit organe de réception pourvu de l'évidement et lesdites tiges de contrôle et, d'autre part, un système de blocage comprenant lesdits moyens de détection et lesdits moyens de blocage, ledit système de contrôle et ledit système de blocage constituant deux systèmes indépendants susceptibles d'être séparés l'un de l'autre et d'être assemblés ensemble pour réaliser un contrôle.

Ainsi, grâce à l'invention, on peut utiliser successivement, lors des contrôles, un seul et même système de blocage pour une pluralité de systèmes de contrôle différents, qui sont, quant à eux, bien entendu adaptés à chaque fois au connecteur à recevoir et à contrôler.

Avantageusement, le système de contrôle et le système de blocage sont assemblés ensemble à l'aide d'un moyen de fixation à glissière longitudinale, par exemple du type en queue d'aronde ou analogue.

Afin d'améliorer encore le guidage et d'augmenter la force de maintien du connecteur dans ledit évidement, le dispositif conforme à l'invention peut être complété, avantageusement, par un système de blocage auxiliaire identique audit système de blocage, ledit système de blocage et ledit système de blocage auxiliaire étant agencés simultanément de part et d'autre dudit système de contrôle.

Les figures du dessin annexé feront bien comprendre comment l'invention peut être réalisée. Sur ces figures, des références identiques désignent des éléments semblables.

La figure 1 est une coupe longitudinale schématique d'un dispositif de contrôle conforme à l'invention, en position de déblocage.

La figure 2 est une coupe semblable à celle de la figure 1, le dispositif de contrôle étant en position de blocage.

La figure 3 est une coupe longitudinale d'un premier mode de réalisation du dispositif de contrôle conforme à l'invention.

La figure 4 est une coupe longitudinale d'un second mode de réalisation du dispositif de contrôle conforme à l'invention, selon la ligne IV-IV de la figure 5.

La figure 5 est une vue en plan du dispositif de contrôle de la figure 4.

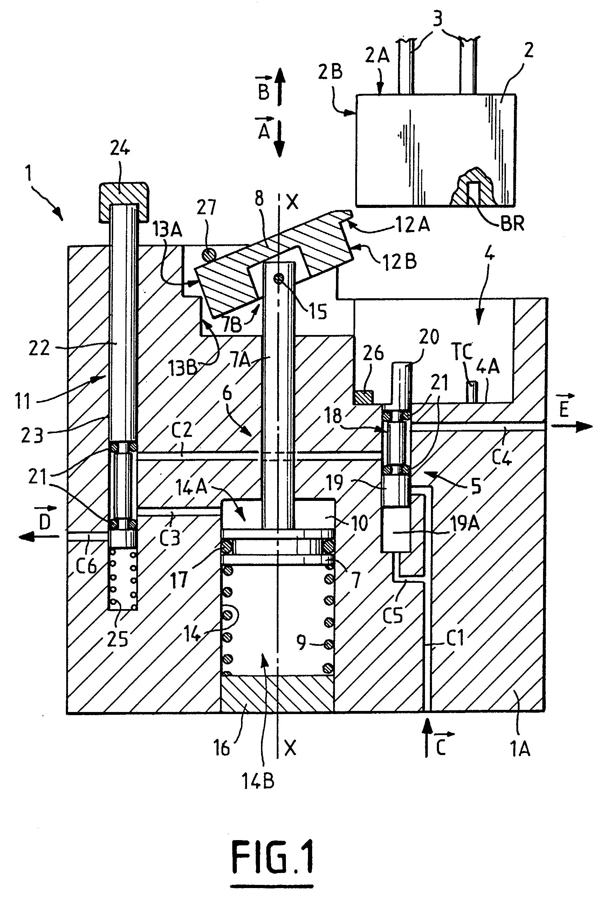

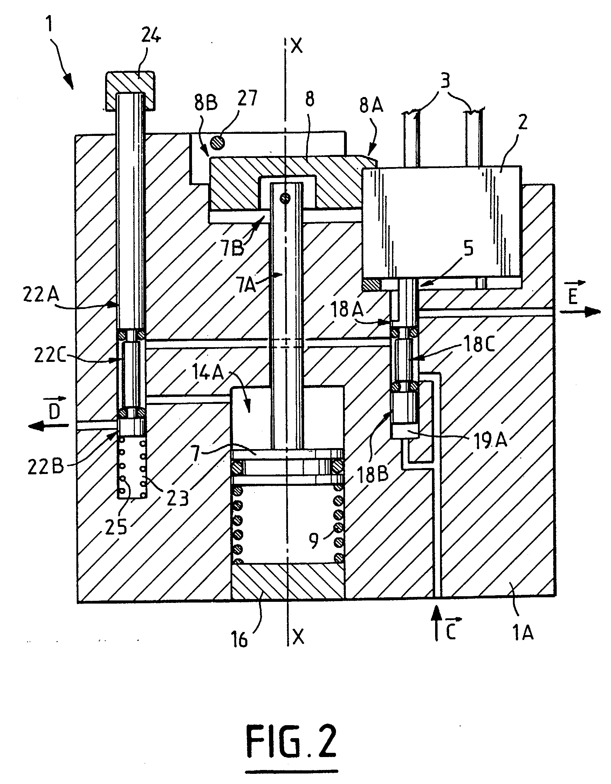

Le dispositif de contrôle 1, conforme à l'invention et représenté schématiquement sur les figures 1 et 2 respectivement dans une position de déblocage et une position de blocage, est destiné à contrôler un connecteur électrique 2 comportant des broches BR, auxquelles sont reliées mécaniquement et électriquement les extrémités de conducteurs électriques 3 destinés, par exemple, à être montés sur un véhicule automobile.

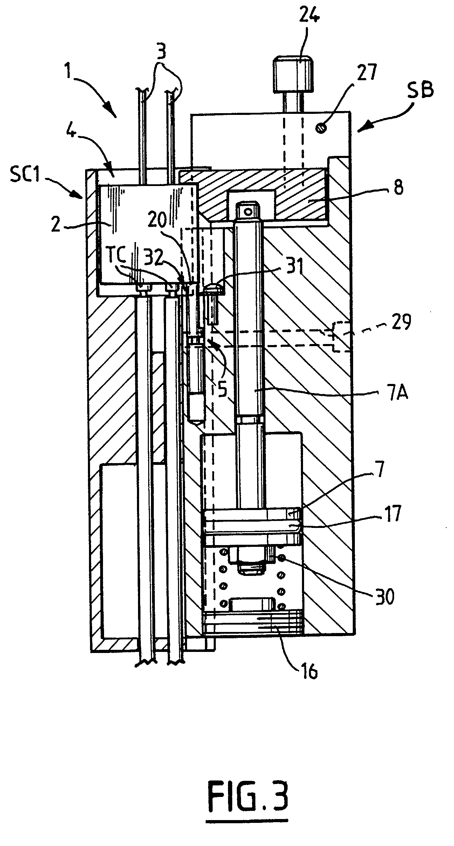

Les figures 1 et 2 doivent être considérées comme des vues schématiques destinées à bien faire comprendre le principe de fonctionnement du dispositif de contrôle 1 conforme à l'invention, ce dernier étant représenté dans deux modes de réalisation particuliers sur les figures 3 à 5.

De façon connue, ledit dispositif de contrôle 1 comporte :

- un organe de réception qui est pourvu d'un évidement 4, de forme correspondant à celle dudit connecteur 2, et susceptible de recevoir ledit connecteur 2, et qui est muni au fond 4A dudit évidement 4 de tiges de contact connues TC (dont une seule est représentée sur les figures 1 et 2), connectées électriquement à un appareil de contrôle non représenté et disposées de manière correspondant à celle des broches BR du connecteur 2 ;
- des moyens de détection 5 pour détecter l'introduction dudit connecteur 2 dans ledit évidement 4 ; et
- des moyens de blocage permettant de bloquer ledit connecteur 2 dans ledit évidement 4, dans une position de blocage représentée sur la figure 2, pour laquelle lesdites broches BR sont en contact d'aboutement avec lesdites tiges de contact TC.

A cet effet, lesdits moyens de blocage comportent :

- un organe mobile 6 comportant un piston 7 mobile dans les deux sens $\vec{A}$ et $\vec{B}$, selon un axe X-X, parallèlement à la direction longitudinale d'introduction et d'extraction dudit connecteur 2, dans ledit évidement 4, susceptible de prendre deux positions extrêmes représentées respectivement sur les figures 1 et 2 ;
- un loquet 8 monté sur ledit organe mobile 6 et susceptible pour l'une desdites positions extrêmes dudit organe mobile, tel que représenté sur la figure 1, de dégager complètement ledit évidement 4 pour permettre la libre introduction et la libre extraction dudit connecteur 2, dans ledit évidement 4, et, pour l'autre position extrême dudit organe mobile 6, tel que représenté sur la figure 2, de prendre appui sur ledit connecteur 2 pour le bloquer dans ledit évidement 4 dans ladite position de blocage, en pressant lesdites broches BR contre lesdites tiges de contact TC ; et
- des moyens d'actionnement 9 et 10 dudit organe mobile 6 commandés dans le sens de blocage $\vec{A}$, par lesdits moyens de détection 5, et, dans le sens du déblocage $\vec{B}$, par un organe de déblocage 11 précisé ci-dessous.

Le dispositif de contrôle 1 conforme à l'invention est réalisé de manière à permettre notamment, de façon simple et peu coûteuse, une introduction sûre et précise dudit connecteur 2 dans ledit évidement 4.

A cet effet, selon l'invention :

- ledit loquet 8 est monté flottant sur ledit organe mobile 6, plus précisément à l'extrémité libre 7B de la tige 7A dudit piston 7, au moyen d'un tourillon 15 ;
- ledit loquet 8 présente, à son extrémité 8A en regard de l'évidement 4, une face 12A destinée à venir au contact de la face arrière 2A du connecteur 2 et une face 12B destinée à venir au contact d'une face latérale 2B dudit connecteur 2, lors du déplacement dudit organe mobile 6 dans le sens du blocage $\vec{A}$, tel que représenté sur la figure 2 ; et
- ledit loquet 8 présente, à son extrémité 8B opposée à l'évidement 4, une face 13A destinée à venir au contact d'une face d'appui 13B dudit dispositif de contrôle, parallèle à la direction longitudinale X-X, et à coulisser sur cette face d'appui 13B, lors du déplacement dudit organe mobile 6 dans le sens du blocage $\vec{A}$, de manière à maintenir ledit loquet 8 dans un plan sensiblement orthogonal à ladite direction longitudinale X-X.

Ainsi, grâce à l'invention, lors du déplacement dudit organe mobile 6 dans le sens du blocage $\vec{A}$, ledit loquet 8 maintenu dans un plan sensiblement orthogonal à la direction longitudinale, exerce sur ledit connecteur 2 simultanément :

- par l'intermédiaire de la face 12B, une poussée latérale réalisant le guidage dudit connecteur 2 dans ledit évidement 4 ; et
- par l'intermédiaire de la face 12A, une poussée longitudinale, parallèle à l'axe X-X, provoquant l'introduction complète dudit connecteur 2 dans ledit évidement 4.

Par conséquent, le connecteur 2 ne risque pas de se mettre de biais dans l'évidement 4, comme cela est parfois le cas pour des connecteurs longs lors de leur introduction dans des dispositifs de contrôle connus.

De plus, grâce au double contact superficiel, d'une part entre les faces 2A et 12A et, d'autre part, entre les faces 2B et 12B, l'introduction du connecteur 2 est stabilisée, ce qui permet d'obtenir un bon positionnement du connecteur 2 dans l'organe de réception du dispositif de contrôle 1.

D'autres avantages de l'invention seront précisés dans la suite de la description.

Comme on peut le voir sur les figures 1 et 2, le piston 7 qui est susceptible de se déplacer dans un espace cylindrique 14, de diamètre sensiblement égal au diamètre dudit piston 7, délimite deux parties 14A et 14B dans ledit espace cylindrique 14, formant chacune une chambre de volume variable en fonction de la position longitudinale, le long de l'axe X-X, dudit piston 7 dans ledit espace cylindrique 14.

La chambre 14B la plus éloignée du loquet 8 est munie d'un ressort 9 prenant appui, d'une part, sur ledit piston 7 et, d'autre part, sur un support fixe 16 prévu dans ledit espace cylindrique 14. Ledit ressort 9 exerce une pression sur ledit piston 7 susceptible de déplacer l'organe mobile 6 dans le sens $\vec{B}$.

La chambre 14A, quant à elle, peut être remplie d'un fluide sous pression 10, par exemple de l'air comprimé, fourni par une source de fluide sous pression non représentée et raccordée au dispositif de contrôle 1, tel qu'indiqué par une flèche $\vec{C}$, et acheminé dans la chambre 14A par l'intermédiaire d'un ensemble de canaux C1, C2 et C3.

Le piston 7 est muni d'un joint d'étanchéité 17 destiné à empêcher le passage du fluide sous pression 10 de la chambre 14A vers la chambre 14B.

Sur ledit ensemble de canaux C1, C2 et C3 sont agencés, d'une part entre les canaux C1 et C2, lesdits moyens de détection 5 et, d'autre part, entre les canaux C2 et C3, ledit organe de déblocage 11.

Lesdits moyens de détection 5 comportent une tige cylindrique 18, qui est susceptible de se déplacer dans un évidement cylindrique 19 prévu dans le fond 4A de l'évidement 4, parallèlement à l'axe X-X, et qui porte un talon 20 débouchant à l'intérieur dudit évidement 4.

Le connecteur 2 qui est introduit dans l'évidement 4 vient buter contre ce talon 20 et est susceptible alors d'exercer une pression sur ce dernier.

La tige cylindrique 18 présente deux tronçons cylindriques extrêmes 18A et 18B de diamètres sensiblement égaux au diamètre de l'évidement cylindrique 19 et un tronçon cylindrique central 18C, de diamètre plus réduit et séparé desdits tronçons cylindriques extrêmes 18A et 18B respectivement par l'intermédiaire de joints d'étanchéité 21.

La tige cylindrique 18 non entièrement introduite dans l'évidement cylindrique 19 forme une chambre 19A au fond de celui-ci.

Audit évidement cylindrique 19 sont reliés les canaux C1 et C2, ainsi qu'un canal C4 raccordé à l'atmosphère et un canal C5 raccordé respectivement audit canal C1 et à ladite chambre 19A.

L'organe de déblocage 11, quant à lui, comporte également une tige cylindrique 22, qui est susceptible de se déplacer dans un évidement cylindrique 23 parallèle à l'axe X-X, et qui porte à une extrémité débouchant à l'extérieur du dispositif 1 un poussoir 24, susceptible d'être pressé manuellement.

La tige cylindrique 22 présente également, comme la tige cylindrique 18, deux tronçons cylindriques extrêmes 22A et 22B de diamètres sensiblement égaux au diamètre de l'évidement cylindrique 23, et un tronçon cylindrique central 22C, de diamètre plus réduit et séparé desdits tronçons cylindriques extrêmes 22A et 22B, respectivement par l'intermédiaire de joints d'étanchéité 21.

L'extrémité de la tige cylindrique 22, opposée à celle portant le poussoir 24, est soumise à l'action d'un ressort 25 qui prend de plus appui sur le fond de l'évidement cylindrique 23.

Audit évidement cylindrique 23 sont reliés les canaux C2 et C3, ainsi qu'un canal C6 raccordé à l'atmosphère.

L'introduction et l'extraction du connecteur 2, dans le dispositif de contrôle 1 conforme à l'invention décrit précédemment, sont réalisées comme suit.

Pour réaliser l'introduction du connecteur 2, à partir de la position de la figure 1, on entre tout d'abord manuellement le connecteur 2 dans l'évidement 4 jusqu'à ce qu'il prenne appui sur le talon 20. Puis on presse ledit connecteur 2 sur ledit talon 20 de manière à déplacer la tige cylindrique 18, contre la pression du fluide présent dans la chambre 19A, jusqu'à ce que le tronçon central 18C de la tige cylindrique 18 soit en regard du canal C1, ce qui provoque alors les actions suivantes :

-   le fluide sous pression 10 alimenté comme indiqué par la flèche $\vec{C}$, pénètre dans la chambre 14A, en traversant successivement le canal C1, le tronçon central 18C de la tige 18, le canal C2, le tronçon central 22C de la tige 22 et le canal C3 ;
-   la pression de la chambre 14A augmente de manière à déplacer le piston 7 dans le sens de blocage $\vec{A}$, en comprimant le ressort 9 ;
-   au cours de ce déplacement, le loquet 8 prend appui par ses faces 12A et 12B respectivement sur les faces 2A et 2B du connecteur 2, et il guide et presse longitudinalement ledit connecteur 2, comme précisé ci-dessus, jusqu'à ce que ce dernier arrive au contact d'une butée fixe 26 au fond 4A de l'évidement 4. Cette position correspond à la position de blocage de la figure 2.

Dans cette position de blocage pour laquelle les broches BR du connecteur 2 sont pressées contre les tiges de contact TC du dispositif de contrôle 1, on peut effectuer les différents contrôles souhaités.

Généralement, pour réaliser l'extraction du connecteur 2, à partir de la position de la figure 2, on coupe l'arrivée de l'air par le canal C1. Le connecteur 2 est alors éjecté par la détente des tiges de contrôle TC, qui sont réalisées de façon élastique et qui sont contraintes lors de la mise en place du connecteur 2.

Toutefois, l'extraction dudit connecteur 2 peut également être réalisée à l'aide de l'organe de déblocage 11, notamment lorsqu'un défaut est détecté et/ou lorsque le connecteur 2 est bloqué dans l'évidement 4.

Dans ce cas, pour réaliser l'extraction du connecteur 2, à partir de la position de la figure 2, on presse le poussoir 24, et donc la tige cylindrique 22, contre l'action du ressort 25, jusqu'à ce que le tronçon central 22C de ladite tige cylindrique 22 soit en regard du canal C6, ce qui provoque alors les actions suivantes :

- le fluide sous pression 10 contenu dans la chambre 14A s'échappe vers l'extérieur comme indiqué par une flèche $\vec{D}$, en traversant successivement le canal C3, ledit tronçon central 22C et le canal C6 ;
- la pression baisse dans la chambre 14A et le piston 7 est déplacé dans le sens de déblocage $\vec{B}$, sous l'action du ressort 9 comprimé ;
- simultanément, le connecteur 2 est pressé vers l'extérieur par la tige cylindrique 18 sous l'action du fluide sous pression présent dans la chambre 19A ;
- au cours de ce déplacement, vers la fin de la course du piston 7, l'extrémité 8B du loquet 8 prend appui contre une butée transversale 27, ce qui provoque le basculement dudit loquet 8, qui libère alors complètement l'évidement 4 et permet d'extraire le connecteur 2 de l'évidement 4.

On remarquera que, -lorsque, au cours des opérations précédentes, on relâche le poussoir 24 de sorte que la tige cylindrique 22 reprenne la position représentée sur les figures 1 et 2, le fluide sous pression 10 présent dans la chambre 14A est évacué vers l'extérieur comme indiqué par une flèche $\vec{E}$ en traversant successivement le canal C3, le tronçon central 22C de la tige 22, le canal C2, le tronçon central 18C de la tige 18 et le canal C4, ce qui permet, malgré le relâchement du poussoir 24, la poursuite du déplacement du piston 7 dans le sens du déblocage $\vec{B}$, de la manière décrite précédemment.

Sur les schémas de principe des figures 1 et 2, tous les éléments du dispositif de contrôle 1 sont intégrés dans un seul bloc 1A.

Toutefois, en pratique, on réalise avantageusement ledit dispositif de contrôle 1 à partir de deux systèmes séparés, un système de contrôle SC1 ou SC2 et un système de blocage SB, tel que représenté sur les figures 3 à 5 qui montrent deux modes de réalisation particulièrement avantageux de l'invention, décrits ci-dessous.

Sur ces figures 3 à 5, on a désigné des éléments semblables à ceux des figures 1 et 2 par les mêmes références, même lorsque leur positionnement dans le dispositif de contrôle 1 est différent.

On notera de plus que, dans un but de clarification du dessin, on n'a pas représenté sur ces figures 3 à 5 les canaux pour l'alimentation en fluide sous pression. Bien entendu, ces canaux et le mode d'alimentation correspondant font partie intégrante du dispositif de contrôle conforme à l'invention et la manière dont ces éléments doivent être agencés est, sans conteste, évidente pour un homme du métier, à partir des explications précédentes relatives aux figures 1 et 2.

Comme indiqué précédemment, le dispositif de contrôle 1 de la figure 3 qui est destiné à contrôler un connecteur 2 muni de deux broches reliées à des conducteurs électriques 3 comporte un système de contrôle SC1 et un système de blocage SB, assemblés ensemble comme explicité ci-dessous.

Selon l'invention, ledit système de contrôle SC1 comprend notamment l'organe de réception pourvu de l'évidement 4 et les tiges de contact TC, tandis que ledit système de blocage SB comprend notamment les moyens de détection 5 et les moyens de blocage 6, 8, 9, 10.

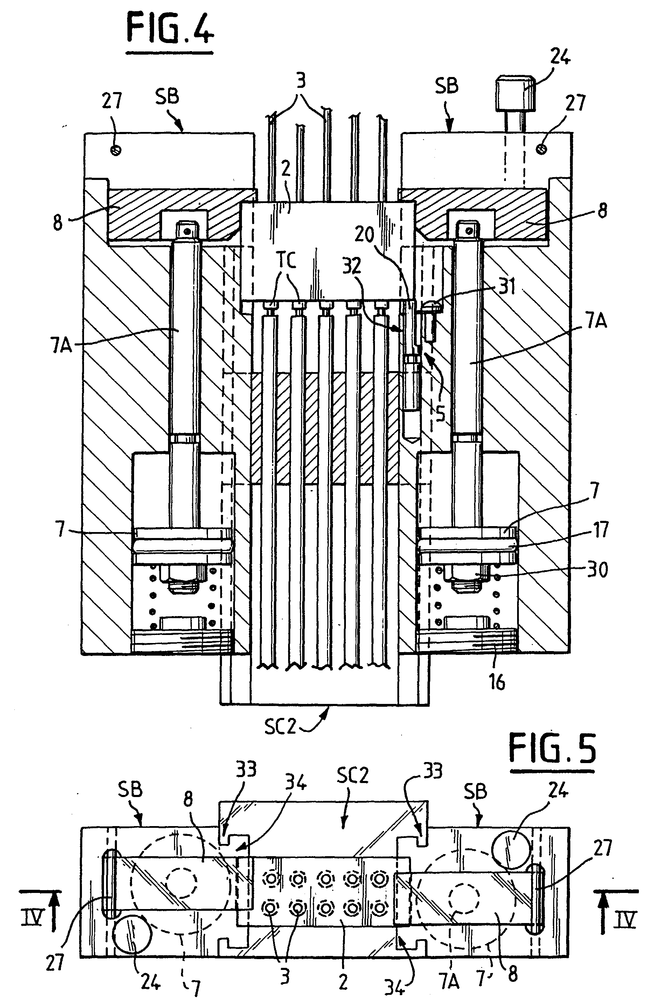

Grâce à l'invention, on peut séparer le système de blocage SB du système de contrôle SC1 et utiliser ce système de blocage SB pour un autre système de contrôle, comme par exemple le système de contrôle SC2 des figures 4 et 5.

Ainsi, lorsque l'on désire contrôler un nouveau connecteur présentant une forme différente du connecteur précédent, il suffit d'adapter ledit système de contrôle à ce nouveau connecteur (et non tout le dispositif de contrôle 1).

L'assemblage des deux systèmes SB et SC1 est réalisé à l'aide d'un moyen de fixation à glissière longitudinale, précisé ci-dessous en référence aux figures 4 et 5. La position longitudinale relative entre lesdits systèmes SB et SC1 est maintenue à l'aide d'une vis 29 représentée schématiquement, qui traverse le système de blocage SB et est fixée dans le système de contrôle SC1.

De plus, comme on peut le voir sur la figure 3 :

- le piston 7 est maintenu sur la tige de piston 7A à l'aide d'un écrou 30 ; et
- le talon 20 des moyens de détection 5 est maintenu par une vis de fixation 31 et il pénètre, à travers une ouverture latérale 32 du système de contrôle SC1, prévue en regard du système de blocage SB dans la position assemblée de la figure 3, dans l'évidement 4 dudit système de contrôle SC1, afin de pouvoir détecter l'introduction d'un connecteur 2 dans cet évidement 4.

Le dispositif de contrôle des figures 4 et 5 est, quant à lui, destiné au contrôle d'un connecteur 2 comportant dix broches reliées à des conducteurs électriques 3.

A cet effet, ledit dispositif de contrôle comporte :

- un système de contrôle SC2 adapté audit connecteur 2 ; et
- deux systèmes de blocage SB identiques et assemblés audit système de contrôle SC2, de part et d'autre de ce dernier.

Ce mode de réalisation à double système de blocage permet notamment :

- un meilleur guidage du connecteur 2 lors de sa mise en place ; et
- une fixation plus sûre dudit connecteur 2 dans l'évidement 4 lors des contrôles.

Par ailleurs, comme on peut le voir sur la figure 5, le moyen de fixation à glissière, pour assembler ensemble les systèmes de contrôle et de blocage, est obtenu en réalisant les faces 33 et 34, respectivement du système de contrôle SC2 et du système de blocage SB, destinées à être assemblées ensemble, selon des formes adaptées et coopérantes, munies de bords d'ancrage permettant de faire glisser longitudinalement la face 34 dans la face 33.

**Revendications**

1. Dispositif de contrôle pour un connecteur électrique (2) comportant des broches (BR) auxquelles sont reliées mécaniquement et électriquement les extrémités de conducteurs électriques (3) montés sur ledit connecteur (2), ledit dispositif de contrôle (1) comportant :

   - un organe de réception pourvu d'un évidement (4) de forme correspondant à celle dudit connecteur (2), et susceptible de recevoir ledit connecteur (2) ;
   - des tiges de contact (TC) connectées électriquement à un appareil électrique de contrôle et disposées de manière correspondant à celle desdites broches (BR) ;
   - des moyens de détection (5) pour détecter l'introduction dudit connecteur (2) dans ledit évidement (4) ; et
   - des moyens de blocage permettant de bloquer ledit connecteur (2) dans ledit évidement (4), dans une position de blocage pour laquelle lesdites broches (BR) sont en contact d'aboutement avec lesdites tiges de contact (TC), lesdits moyens de-blocage comprenant :

      . un organe mobile (6) dans les deux sens ($\vec{A}$, $\vec{B}$), parallèlement à la direction longitudinale d'introduction et d'extraction dudit connecteur (2), dans ledit évidement (4), susceptible de prendre deux positions extrêmes ;
      . un loquet (8) monté sur ledit organe mobile (6) et susceptible pour l'une desdites positions extrêmes dudit organe mobile (6) de dégager complètement ledit évidement (4) pour permettre la libre introduction par l'avant et la libre extraction dudit connecteur (2), dans ledit évidement (4), et, pour l'autre position extrême dudit organe mobile (6) de prendre appui sur ledit connecteur (2) pour le bloquer dans ledit évidement (4) dans ladite position de blocage, en pressant lesdites broches (BR) contre lesdites tiges de contact (TC) ; et
      . des moyens d'actionnement (9, 10) dudit organe mobile (6) commandés, dans le sens du blocage, par lesdits moyens de détection (5), et, dans le sens du déblocage, par un organe de déblocage (11),

   caractérisé en ce que ledit loquet (8) est monté flottant sur ledit organe mobile (6), en ce que l'extrémité (8B) dudit loquet (8), opposée à l'évidement (4), présente une face (13A) destinée à venir au contact d'une face d'appui (13B) dudit dispositif de contrôle, parallèle à ladite direction longitudinale, et à coulisser sur cette face d'appui (13B), lors du déplacement dudit organe mobile (6) dans le sens du blocage ($\vec{A}$), de manière à maintenir ledit loquet (8) dans un plan sensiblement orthogonal à ladite direction longitudinale, et en ce que l'extrémité (8A) dudit loquet (8), en regard dudit évidement (4), présente une première face (12A) destinée à venir au contact de la face arrière (2A) dudit connecteur (2) et une seconde face (12B) destinée à venir au contact d'une face latérale (2B) dudit connecteur (2), lors du déplacement dudit organe mobile (6) dans le sens du blocage ($\vec{A}$), de sorte que ledit loquet (8) exerce sur ledit connecteur (2), lors d'un tel déplacement dudit organe mobile (6), simultanément :
   - une poussée latérale réalisant le guidage dudit connecteur (2) dans ledit évidement (4) ; et
   - une poussée longitudinale provoquant l'introduction complète dudit connecteur (2) dans ledit évidement (4).

2. Dispositif de contrôle selon la revendication 1, caractérisé en ce qu'il comporte une butée transversale (27), sur laquelle prend appui l'extrémité (8B) du loquet (8), opposée à l'évidement (4), lors du déplacement de l'organe mobile (6) dans le sens du déblocage ($\vec{B}$), de manière à provoquer le basculement dudit loquet (8) qui dégage alors ledit évidement (4).

3. Dispositif de contrôle selon la revendication 2, caractérisé en ce que le déplacement de l'organe mobile (6) est engendré, dans le sens du blocage ($\vec{A}$), par un fluide sous pression (10), susceptible d'être introduit dans une partie (14A) d'un espace cylindrique (14) entourant ledit organe mobile (6), et, dans le sens du déblocage ($\vec{B}$), par au moins un ressort comprimé (9).

4. Dispositif de contrôle selon la revendication 3, caractérisé en ce que les moyens de détection (5) sont susceptibles de permettre et d'empêcher l'introduction du fluide sous pression (10) dans ladite partie (14A) de l'espace cylindrique (14), lesdits moyens de détection (5) permettant cette introduction lorsqu'ils détectent l'introduction du connecteur (2) dans l'évidement (4).

**5.** Dispositif de contrôle selon l'une des revendications 3 ou 4,
caractérisé en ce que ledit organe de déblocage (11) est formé de manière à relier à l'atmosphère, lorsqu'il est actionné, la partie (14A) dudit espace cylindrique (14) contenant ledit fluide sous pression (10).

**6.** Dispositif de contrôle selon l'une quelconque des revendications précédentes,
caractérisé en ce que lesdits moyens de blocage (6, 8, 9, 10) sont complètement intégrés dans ledit dispositif de contrôle (1).

**7.** Dispositif de contrôle selon l'une quelconque des revendications précédentes,
caractérisé en ce qu'il comporte, d'une part, un système de contrôle (SC1, SC2) comprenant ledit organe de réception pourvu de l'évidement (4) et lesdites tiges de contrôle (TC) et, d'autre part, un système de blocage (SB) comprenant lesdits moyens de détection (5) et lesdits moyens de blocage (6, 8, 9, 10), ledit système de contrôle (SC1, SC2) et ledit système de blocage (SB) constituant deux systèmes indépendants susceptibles d'être séparés l'un de l'autre et d'être assemblés ensemble pour réaliser un contrôle.

**8.** Dispositif de contrôle selon la revendication 7,
caractérisé en ce que le système de contrôle (SC1, SC2) et le système de blocage (SB) sont assemblés ensemble à l'aide d'un moyen de fixation à glissière longitudinale (33, 34).

**9.** Dispositif de contrôle selon l'une quelconque des revendications 7 ou 8,
caractérisé en ce qu'il comporte de plus un système de blocage auxiliaire (SB) identique audit système de blocage (SB), ledit système de blocage (SB) et ledit système de blocage auxiliaire (SB) étant agencés simultanément de part et d'autre du même système de contrôle (SC2).

FIG.1

# FIG.2

# FIG.3

# FIG.4

# FIG.5

**Office européen
des brevets**

**RAPPORT DE RECHERCHE EUROPEENNE**

Numero de la demande
EP 96 40 2147

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A,D | FR-A-2 690 250 (HERNANDEZ)<br>* revendication 1 *<br>--- | 1 | G01R31/04<br>H01R13/629 |
| A | DE-C-39 14 523 (DEUTSCHE GESELLSCHAFT FUR WIEDERAUFARBEITUNG VON KERNBRENNSTOFFEN MBH)<br>* figure 1 *<br>--- | 1 | |
| A | US-A-4 579 408 (SASAKI)<br>* revendication 1 *<br>--- | 1 | |
| A | DE-A-44 29 442 (YAZAKI CORP)<br>* figure 5B *<br>----- | 1 | |

**DOMAINES TECHNIQUES RECHERCHES (Int.Cl.6)**

G01R
H01R

Le présent rapport a été établi pour toutes les revendications

| Lieu de la recherche | Date d'achèvement de la recherche | Examinateur |
|---|---|---|
| LA HAYE | 22 Novembre 1996 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant